(19) Europäisches Patentamt
European Patent Office
Office européen des brevets

(11) **EP 1 403 708 A2**

(12) # EUROPEAN PATENT APPLICATION

(43) Date of publication:
**31.03.2004 Bulletin 2004/14**

(51) Int Cl.[7]: **G03F 7/031**

(21) Application number: **03256124.3**

(22) Date of filing: **29.09.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **30.09.2002 US 414758 P**

(71) Applicant: **Shipley Co. L.L.C.**
**Marlborough, MA 01752 (US)**

(72) Inventors:
- **Barr, Robert K.**
  **Shrewsbury, Massachusetts 01545 (US)**
- **Anzures, Edgardo**
  **Westborough, Massachusetts 01581 (US)**
- **Lundy, Daniel E.**
  **Winchendon, Massachusetts 01475 (US)**

(74) Representative: **Kent, Venetia Katherine et al**
**Rohm and Haas (UK) Ltd**
**European Operations Patent Dept.**
**Lennig House**
**2 Mason's Avenue**
**Croydon, CR9 3NB (GB)**

(54) **Photoresist**

(57) A photoresist which contains a hydrophilic compound that generates a free-radical polymerization initiator upon exposure to actinic radition. The hydrophilic compound may be employed as a binder polymer or cross-linking agent in a photoresist.

EP 1 403 708 A2

## Description

Background of the Invention

The present invention is directed to an improved photoresist. More specifically, the present invention is directed to an improved photoresist which includes a hydrophilic compound which generates a free-radical polymerization initiator which is integral to the compound.

Photoresists are photosensitive films used for transfer of images to a substrate. A coating layer of a photoresist is formed on a substrate and the photoresist layer is then exposed through a photomask to a source of activating radiation. The photomask has areas that are opaque to activating radiation and other areas that are transparent to activating radiation. Exposure to activating radiation provides a photoinduced chemical transformation of the photoresist coating to thereby transfer the pattern of the photomask to the photoresist-coated substrate. Following exposure, the photoresist is developed to provide a relief image that permits selective processing of a substrate.

A photoresist can be either positive-acting or negative-acting. For most negative-acting photoresists, those coating layer portions that are exposed to activating radiation polymerize or cross-link in a reaction between a photoactive compound and polymerizable agents of the photoresist composition. Consequently, the exposed coating portions are rendered less soluble in a developer solution than unexposed portions. For positive-acting photoresists, exposed portions are rendered more soluble in a developer solution while areas not exposed remain comparatively less developer soluble.

Photoresist compositions include at least a resin binder component, a monomer or oligomer and a photoactive agent. A wide variety of polymeric or resin binders may be used in photoresists. Such polymeric binders may include, as polymerized components, one or more acid functional monomers such as acrylic acid or methacrylic acid. Photoresists may be employed in a number of industries. Such industries include, but are not limited to, the electronics industry such as in the manufacture of printed wiring boards, photomasks, planographic printing plates and semiconductors, the manufacture of color filters for use in color liquid crystal display devices, color image pick-up elements, and the like. For example, U.S. Patent No. 5,952,153 (Lundy et al.) discloses photoimageable compositions containing polymeric binders having sufficient acid functionality to render the photoimageable composition developable in alkaline aqueous solution. U.S. Patent No. 4,537,855 (Ide) discloses polycarboxylic acids used to form polymerizable ester derivatives with ethylenically unsaturated compounds. Such polymerizable ester derivatives are used to form the polymeric binders for photoimageable compositions.

Monomers useful in photoresist compositions are any which are cross-linkable. Such monomers cross-link to form a polymerized network having a very large, i.e. infinite, molecular weight. The polymeric binders do not participate in such cross-linking. Rather, the monomers form a polymerized network around the polymeric binders. Polymeric binders may contain pendant groups, such as carboxylic acids that react with the developer to increase the water solubility of the binder. Thus, in the unexposed portion, the acid functional polymer is salted in the alkaline solution, while in the exposed area (protected by the cross-linked monomers), the polymer is not affected. During stripping, the polymerized network (of cross-linking monomers) is attacked or degraded by the stripper allowing it to be removed, whereas the polymeric binder remains relatively unaffected by such strippers.

Photoresists also may be either liquid or dry film. Liquid photoresists are dispensed on a substrate and then cured. Dry film photoresists may be laminated to a substrate. Such dry film photoresists are particularly suitable for use in printed wiring board manufacture. One problem with many dry film photoresist compositions is that they are difficult to strip from electrolytically plated circuit boards using conventional alkaline aqueous stripping solutions, e.g. 3% sodium hydroxide solution. This problem arises from the demand of circuit board manufacturers to reduce the size of printed circuit boards, while increasing their functional capabilities. Consequently, the circuit lines and spaces on the circuit boards have continued to shrink, as more circuitry needs to be accommodated in smaller spaces. At the same time, metal plating heights have also increased above the thickness of the photoresist. This causes the metal to hang over the photoresist, resulting in a very narrow space containing the photoresist being virtually encapsulated by the overplated metal. The photoresist then becomes trapped by the plated overhang, making it difficult to attack and strip by conventional methods. If the photoresist is not completely stripped or removed, ragged copper circuit lines will result after etching which are unsuitable as they can cause short circuiting of the board.

Some circuit board manufacturers have tried thicker photoresists to accommodate the increasing plating heights, however, this approach is more expensive and limits resolution of the circuit lines. Typically, organic-based (amine- or organic solvent-containing) alkaline stripping solutions are used which produce a smaller stripped particle to facilitate stripping. While such organic-based strippers remove the resist better, they are expensive relative to inorganic-based strippers (e.g. sodium or potassium hydroxide) and have more waste treatment and environmental concerns associated with them. Solvent-strippable photoresists are much less desirable due to workplace regulations limiting or reducing solvent emissions.

Certain polymer binders have been described optionally containing one or more multifunctional monomers.

For example, U.S. Patent No. 5,939,239 (Lundy et al.) discloses polymer binders containing acid functional monomers optionally copolymerized with another monomer, including certain multifunctional monomers. The multifunctional monomers disclosed are tri- or tetra-functional (meth)acrylate esters or relatively low molecular weight, i.e. typically ≤ 450, difunctional (meth)acrylate esters. Polymer binders containing such tri- and tetra-functional monomers or such relatively low molecular weight difunctional (meth)acrylate esters suffer from gel formation, which makes such polymers unsuitable for use in photoresist compositions. It is thus desirable to provide photoresist compositions that are easily removed using alkaline aqueous inorganic-based stripping solutions, and that do not form gels.

Another problem associated with many photoresists is the build-up of organic scum and residue from uncured photoresist. Such organic scum and residue may deposit on various articles and apparatus during the manufacture of products made using photoresists such as printed wiring boards, developer solutions and developer apparatus. Much of the organic scum and residue is caused by $\alpha,\beta$-ethylenically unsaturated monomers and oligomers such as (meth) acrylate-based compounds, and photoactive agents having numerous aromatic groups in their structures. Examples of such photoactive agents that may form part of the scum and residue include, but are not limited to, imidazole dimers, benzophenones, acetophenones, anthraquinones, naphthaquinones, triazine-based compounds and the like. Such contaminants are not readily water-soluble or readily water-emulsifiable after they form residues in solution or deposit on an article or apparatus. As dissolved photoresist builds up in solution (developer loading), insoluble organic materials begin to form in the developing tank eventually forming a water-insoluble residue or scum. Presence of anti-foam additives (added to developer solutions to minimize foaming) greatly increases the tendency for residue and scum to form. As the level of scum builds, chances increase for a redeposit of the water-insoluble residues onto the developed circuit board. Such redeposited residues cause a retardation of etching solution (etching chemistries have difficulty penetrating organic residues). Where etch is retarded, circuit shorts form causing a defective circuit board. In addition to increasing the potential for defective circuit boards, the residue also makes cleaning equipment difficult, thus increasing maintenance time and cost.

In addition to the problem of built-up residue and scum formation from primary photoresists, there also is a residue and scum build-up problem from secondary photoresists. Such secondary photoresists may be employed in soldermasks. Residue and scum are deposited on a substrate as a result of component separation in the soldermask. Such component separation may be exacerbated when an improperly balanced soldermask developer solution, i.e., improper developing conditions and/or soldermask developer solution chemistry, contact the soldermask. Built-up residue and scum from secondary photoresists may appear as a bright green coating on a substrate such as a developer apparatus.

Cleaners are available for removing residue and scum. However, such cleaners are primarily used because of the low cost of their ingredients. Workers in the field using such cleaners have discovered that the residue problem often is made worse. Often the equipment has to be manually cleaned to remove the residue from the photoresist as well as any residue from the cleaners. Such manual cleaning is both a labor and time intensive operation that can cause a significant loss of production time. Further, such cleaners are not effective enough for removing residue from many new generation photoresists that have numerous hydrophobic aromatic components.

Although there are compositions available for cleaning scum and residue formation from photoresists, a photoresist that eliminates or at least reduces components that cause scum and residue formation is more desirable than employing one or more cleaning compositions. Such a photoresist provides for a more efficient process for manufacturing articles since cleaning and residue reducing procedures may be eliminated.

U.S. 6,251,569 B1 to Angelopoulos et al. discloses a negative-working photoresist that allegedly does not require any additional photocatalysts, photoinitiators or added cross-linking agents. A polymer component of the photoresist has recurring photosensitive ester groups. When the polymer is exposed to radiation, a redistribution of carbon-oxygen bonds in the ester groups leading to the formation of ester type bridges between polymer chains is alleged to occur. However, the problem of scum and residue formation is not addressed.

U.S. 5,945,489 and U.S. 6,025,410 both to Moy et al. (also see "Novel Resins That Cure Without Added Photoinitiator" by Sheridan et al. Chemistry III-New Chemistry, RadTech 2002, pages 462-474 (Technical Conference Proceedings)) disclose photosensitive compounds which may be cross-linked without an added photoinitiator. The patent discloses that a Michael addition of acetoacetate donors to multifunctional acrylate receptor compounds yields polyesters with reactive pendent methacrylate groups which may be cross-linked in a subsequent curing reaction. The patent states that pendent methyl ketone substituents serve as an internal photoinitiator. Upon exposure to UV radiation, an acyl radical with the methyl substituent is believed to be formed which acts as a photoinitiator, thus photonitiators are not added. Such compounds are sol or liquid oligomers which may be employed as decorative coatings on wood and metal substrates. Further, odor generated from unreacted photoinitiators and skin absorption of unreacted photoinitiators is avoided, thus compositions containing such oligomers may be employed in materials that include medical and food contact applications. However, the photosensitive compounds are not suitable for use in photoresists. The photosensitive compounds do not absorb energy at wavelengths greater than 300 nanometers and are not alkali developable.

Although there are photosensitive compositions that reduce or do not employ added photoinitiators and cross-linking agents, there is still a need for a photoresist which reduces or eliminates added photoinitiators and cross-linking agents to prevent scum and residue formation.

## Summary of the Invention

The present invention is directed to a photoresist which includes a hydrophilic compound which generates a free-radical polymerization initiator integral to the compound upon exposure to actinic radiation. The photoresist of the present invention may be a primary or a secondary photoresist.

Advantageously, photoresists of the present invention prevent or at least inhibit scum and residue formation on substrates. Compounds included in the photoresists generate their own free-radical polymerization initiators, thus added photoinitiators may be avoided, and scum and reside from such photoinitiators of uncured photoresist is prevented. Upon exposure to actinic radiation, a free-radical is generated which acts as a polymerization initiator.

In addition to avoiding added photoinitiators, the compound which generates a free-radical of the present invention may perform as a cross-linking agent, thus additional α,β-ethylenically unsaturated monomers and oligomers may be excluded. Such monomers and oligomers also may be a source of scum and residue build-up. The compound which generates a free-radical of the present invention also may perform as a binder, thus additional polymeric binders may be reduced or eliminated, thus providing a simpler photoresist and further reducing scum and residue formation.

Other advantages of the photoresists include ability to survive acidic process chemicals, and printed wiring board manufacturing processes. The photoresists also are alkali developable. The photoresists also provide improved contrast between exposed and unexposed photoresist.

In addition to the hydrophilic compounds which generate a free-radical, the photoresists may include conventional photoresist components. Such components include, but are not limited to, plasticizers, rheology modifiers, fillers, dyes, film forming agents, strippers or mixtures thereof.

The photoresist of the present invention is developable with aqueous developer or basic developer solutions. The photoresist has good tenting strength, good strippability, high resolution and is sensitive to light at wavelengths of 300 nm or greater. The photoresists may be cured at low energy doses such as 150 $mJ/cm^2$ or less.

Another embodiment of the present invention provides a method for forming a pattern on a substrate including the steps of: a) disposing on a substrate a photoresist composition with a hydrophilic compound which generates a free-radical polymerization initiator integral to the compound upon exposure to actinic radiation; b) imaging the photoresist; and c) developing the photoresist.

A primary objective of the present invention is to provide a photoresist which has a hydrophilic compound which generates a free-radical upon exposure to actinic radiation.

Another objective of the present invention is to provide a photoresist which reduces or eliminates scum and residue formation.

A further objective of the present invention is to provide for a photoresist which has reduced amounts of photoinitiators.

An additional objective of the present invention is to provide a photoresist which has reduced amounts of α, β-ethylenically unsaturated monomers or oligomers.

Still yet another objective of the present invention is to provide a method of forming an image on a substrate.

Additional objectives and advantages of the present invention are discernable to a person of skill in the art after reading the description of the invention and the appended claims.

## Detailed Description of the Invention

The present invention is directed to a photoresist which includes a hydrophilic compound which generates a free-radical polymerization initiator is integral to the compound. Since the photoresist has a hydrophilic compound which generates a free-radical polymerization initiator, added photoinitiators may be excluded from the photoresist. The photoresist also may exclude additional α,β-ethylenically unsaturated cross-linking agents. The hydrophilic free-radical generating compounds of the present invention may be self-cross-linking when they have unsaturated capping groups or unsaturated pendent groups. A "capping group" is a group which is at a terminus of a compound's backbone. A "pendent group" refers to any group suspended from a compound, i.e., only one end of the group is attached to the compound. Such "pendent groups" are not part of the compound's backbone. Hydrophilic within the scope of the present invention means that the compound is water-soluble or at least water-emulsifiable.

Free-radical generating compounds of the photoresists may be derived from Michael addition reactions of at least one diketone or at least one acetoacetate derivative functional donor compound and at least two multifunctional acrylate receptor compounds. The resulting free-radical generating compound may contain both capping and pendent acrylate groups which are capable of cross-linking upon exposure to actinic radiation. Michael addition reactions are

catalyzed by a strong base such as diazabicyclo-undecene (DBU). Other cyclic amidines, for example diazabicyclo-nonene (DBN) and guanidines, also are suitable for catalyzing Michael addition reactions. U.S. 5,945,489 and U.S. 6,025,410 disclose Michael addition reactions, the entire disclosures of which are hereby incorporated herein in their entireties by reference. Preferably, the hydrophilic compounds which generate a free-radical absorb light at 300 nm or greater.

While any hydrophilic compound that generates a free-radical which is integral to the compound is included within the scope of the present invention, preferred compounds are selected from the group consisting of monomers, oligomers and polymers suitable for use in a photoresist. Such monomers, oligomers and polymers are hydrophilic. Examples of such compounds are described below.

A hydrophilic compound which generates a free-radical polymerization initiator of the present invention may have a general formula:

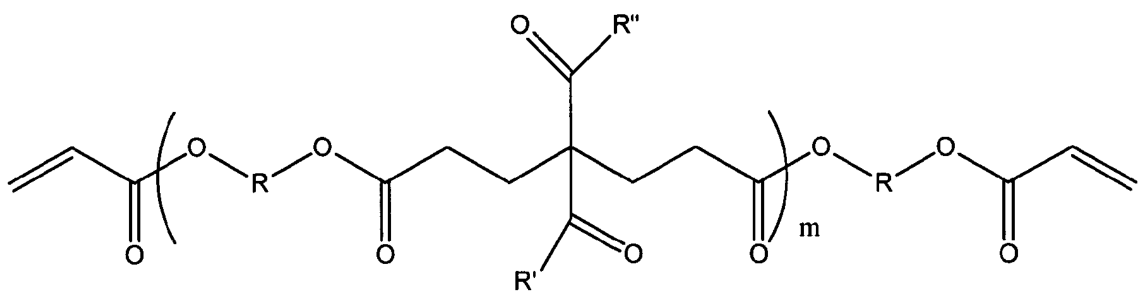

I

where m is an integer of from at least 1, generally from 1 to 100, preferably from 5 to 50, R' and R" may be the same or different and may be groups that provide the oligomer with water-solubility or water-emulsifiability, R' and R" may include, but are not limited to unsubstituted or substituted $(C_6-C_{14})$aryl such as unsubstituted or substituted phenyl, unsubstituted or substituted naphthyl, unsubstituted or substituted anthracenyl, unsubstituted or substituted phenanthryl, linear or branched $(C_1-C_{15})$alkyl, linear or branched $(C_2-C_{15})$hydroxyalky, substituted or unsubstituted $(C_5-C_{14})$ heterocyclic aryl where the heteroatom is S, N, or O, or linear or branched $(C_1-C_5)$ aminylalkyl, $-NR_1R_2$ where $R_1$ and $R_2$ are the same or different and may be hydrogen, $(C_1-C_3)$alkyl or $(C_1-C_4)$hydroxyalkyl. Substituents include, but are not limited to, $(C_1-C_5)$alkoxy, hydroxyl, $(C_1-C_5)$ hydroxyalkyl, $(C_1-C_5)$alkyl, $(C_1-C_5)$carboxyalkyl, $(C_2-C_5)$ ester, $(C_1-C_5)$ aminylalkyl, phenyl, hydroxyphenyl, $-NO_2$, sulfonate, phosphate, -SH, $(C_1-C_5)$thioalkyl, acetyl, benzoyl, aldehyde, $(C_1-C_5)$ketyl, and the like. Preferably, R' or R" is unsubstituted or substituted phenyl, unsubstituted or substituted naphthyl, unsubstituted or substituted anthracenyl, $(C_1-C_8)$alkyl, $(C_2-C_{10})$hydroxyalkyl, unsubstituted or substituted $(C_5-C_{10})$ heterocyclic aryl, or $(C_1-C_5)$aminylalkyl. R' and R" also may be -O-R''' where R''' is the same as R' and R" described above.

R', R" and R''' groups also may absorb light at 300nm to 365nm or greater. The most preferred R', R" and R''' are water-soluble or water-emulsifiable and absorb light at 300nm to 365nm or greater.

R also may be a water-soluble or a water-emulsifiable group. R may be a group which provides sufficient acid groups such that the photoresist may be developed with an aqueous or aqueous base solution. R may have an acid number of at least 50. Preferably, R is water-soluble or water-emulsifiable and absorb light at 300nm or greater. R may be derived from acid functional monomers, non-acid functional monomers, alkylene oxides, polyesters, urethanes, or mixtures thereof. Urethanes are compounds that have at least one —CO(NH)— moiety, and biurets are urethanes that have at least one —NH—CONH—CONH— moiety in the structure. A "moiety" is defined as a distinct structural component. Examples of suitable oligomers are disclosed in U.S. 6,045,973, U.S. 6,166,245, U.S. 6,207,347 B1, U.S. 6,268,111 B1, U.S. 6,319,653, U.S. 6,322,951 B1, and U.S. 6,329,123 B1, the entire disclosures of which are hereby incorporated herein their entireties by reference.

It is believed that the pendent ketone substituents, as shown in formula I, are the source of the free-radical polymerization initiator. Such pendent ketone substituents are integral to the compound and are internal or "built-in" photoinitiators. Integral means that the ketone substitutent is a basic structural component of the compound.

Examples of suitable acid functional monomers are acrylic acid, methacrylic acid, maleic acid, fumaric acid, citraconic acid, 2-acrylamido-2-methylpropanesulfonic acid, 2-hydroxyethyl acrylolyl phosphate, 2-hydroxypropyl acrylol phosphate, 2-hydroxy-alpha-acryloyl phosphate, etc. One or more of such acid functional monomers may be used to form R.

Non-acid functional monomers include, but are not limited to, esters of acrylic acid and methacrylic acid, for

example, methyl acrylate, 2-ethyl hexyl acrylate, n-butyl acrylate, n-hexyl acrylate, methyl methacrylate, hydroxy ethyl acrylate, butyl methacrylate, octyl acrylate, 2-ethoxy ethyl methacrylate, t-butyl acrylate, 1,5-pentanediol diacrylate, N, N-diethylaminoethyl acrylate, ethylene glycol diacrylate, 1,3-propanediol diacrylate, decamethylene glycol diacrylate, decamethylene glycol dimethacrylate, 1,4-cyclohexanediol diacrylate, 2,2-dimethylol propane diacrylate, glycerol diacrylate, tripropylene glycol diacrylate, glycerol triacrylate, 2,2-di(p-hydroxyphenyl)-propane dimethacrylate, triethylene glycol diacrylate, polyoxyethyl-2-2-di(p-hydroxyphenyl)-propane dimethacrylate, triethylene glycol dimethacrylate, polyoxypropyltrimethylol propane triacrylate, ethylene glycol dimethacrylate, butylene glycol dimethacrylate, 1,3-propanediol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, and 1,4-benzenediol dimethacrylate; styrene and substituted styrene, such as 2-methyl styrene and vinyl toluene and vinyl esters, such as vinyl acrylate and vinyl methacrylate to provide the desired acid number. The acid functional monomers may be copolymerized with the non-functional acid monomers.

Specific examples of urethane oligomers from which the R radical may be derived from include, but are not limited to, the following general formulas II and III.

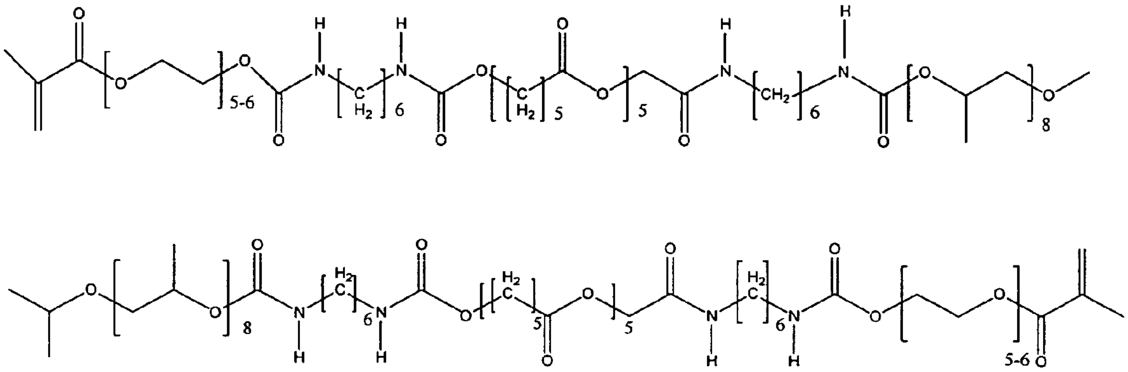

II

Urethane oligomers of formula II (a single compound) may be prepared by any suitable method known in the art. An example of one method for forming the urethane oligomer of formula I involves reacting one mole of polyethylene glycol 300 monomethyacrylate with four moles of caprolactone in a chain opening extension reaction. An acid catalyst may be employed, and the reaction may be run at room temperature, i.e., about 20°C. The product of the reaction is a polycaprolactone extension of polyethylene glycol 300 (block copolymer).

In a separate container, one mole of polypropylene glycol (molecular weight = about 1000) is reacted with two moles of 1,6-hexamethylene diisocyanate using known isocyanate chemical reaction conditions and methods. The product of the reaction is a urethane prepolymer terminated with an isocyanate.

To form the final end product, which is the urethane of formula I, two moles of the polycaprolactone extension of polyethylene glycol 300 is reacted with one mole of the isocyante terminated urethane prepolymer. The reaction is a classic urethane condensation reaction well known in the art. The resulting product is the dimethyacrylate oligomer of formula II.

$$T\text{-}I'\text{-}(\text{-}P'\text{-}I'\text{-})_q\text{-}T \qquad III$$

where I' is an aliphatic, cycloaliphatic, or aromatic isocyanate group having an isocyanate functionality of 2 or greater, preferably an isocyanate derived group of the formula:

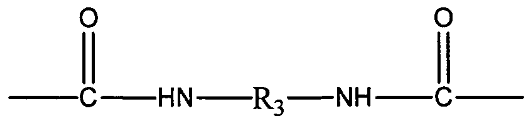

where $R_3$ is an aliphatic, cycloaliphatic, or aromatic hydrocarbon group, with hexamethylene, cyclohexylene, and phenylene preferred, T is a group of the formula:

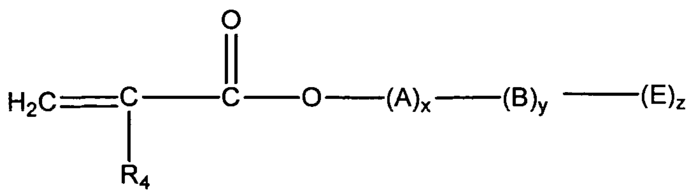

where $R_4$ is hydrogen or methyl, A, B and E are in the order given or in any order, preferably in the order given, A may be an alkylene oxide derived group of the formula:
$—[—(CH_2)_n—O—]—$, where n is an integer from 1 to 20, preferably 2 to 4, and x is an integer from 1 to 40, B may be an alkylene oxide derived radical of the formula: $—[—(CH_2)_{n1}—O—]—$, where n1 is an integer from 1 to 20, preferably 2 to 4, and y is an integer from 0 to 40, with the alkylene oxide derived groups, preferably from 4 to 12, and E is derived from a lactone and is an open ring lactone group of the formula:

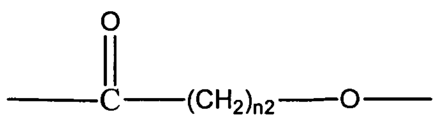

where n2 is an integer from 1 to 20, preferably 3 to 5, and z is an integer from 1 to 40, preferably 3 to 8 and q is 0 or an integer from 1 to 10.

In the above, if q is 1 or more, P' is: —[— O — G —]— where G is of the formula:
$(A)_{s1}—(B)_{s2}—(E)_{s3}—(D)_f—(W)_k—(J)_u—(B)_{s4}—(A)_{s5}—$, where A, B, E and $R_3$ are defined above and f, k, and u are 0 or 1, D is a group of the formula:

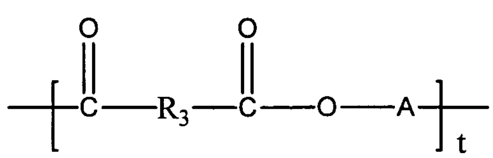

where t is an integer from 1 to 40, W is a group of the formula:

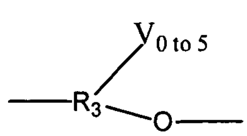

where V is an acidic group selected from —COOH, —$SO_3$ H, and $PO_3$ $HR_5$, $R_5$ is hydrogen or a $C_{1-18}$ alkyl group, J is an ester functional alkyl group of the formula:

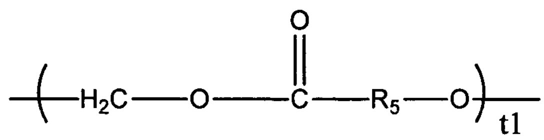

where t1 is an integer from 1 to 6, and, with the proviso that if f+k+u=0, then $\Sigma_{S1 \ldots S5}$ must be >1.

Urethane oligomers of formula III may be prepared by any suitable method. A preferred method of forming urethane oligomers defined in the above formula III where q=0 is to initially block copolymerize one or more lactone derived groups and two or more alkylene oxide derived groups onto a (meth)acrylic acid backbone by a conventional addition polymerization procedure, to produce the (meth)acrylate-functional group of formula T which has a hydroxy-terminus opposite the (meth)acrylate functionality.

While in the above described formula for T, (A), (B) if present, and (E) may theoretically be in any order, the preferred mode of oligomer synthesis dictates that (E) be at the terminus opposite the (meth)acrylate functionality. In the preferred synthetic route, (meth)acrylic acid is reacted with an alkylene oxide monomer to produce (A). If desired, further reaction is carried out with a different alkylene oxide monomer to produce (B). The resulting product is then reacted with a lactone monomer or mixture of lactone monomers to produce (E).

Alkylene oxide monomers used in forming the (A) and (B) alkylene oxide groups may contain 1 to 20 carbon atoms, although short chain alkylene oxides of at least 2 up to 4 carbon atoms, such as ethylene oxide, propylene oxide, and butylene oxide, with ethylene oxide and propylene oxide being preferred. While (B), if present, is herein defined as is (A), (B) is formed from a different monomer from (A). For example (A) may be formed from ethylene oxide and (B) could be formed from propylene oxide, or (A) may be formed from a mixture of ethylene oxide and butylene oxide while (B) may be formed from a mixture of propylene oxide and butylenes oxide. The optional incorporation of (B) allows the oligomer to be tailored to particular applications. To provide sufficient chain length to the oligomer, (A) plus (B) must be formed from at least 2 alkylene oxide monomers total, preferably between 4 and 12 monomers. In addition to alkylene oxides, (A) and (B) may be derived from tetrahydrofuran or styrene oxide with one or more alkylene oxide.

Lactone derived component (E) of the (meth)acrylate functional oligomeric group defined in formula T is formed from 1 to 40 lactone monomer units, either a single lactone species or mixture of lactone species. The lactone species employed may have from 1 to 20 carbon atoms (not including the carbonyl carbon), although 3 to 5 carbon atom species are preferred. Epsilon-caprolactone is a preferred lactone for forming (E). Other suitable lactones include, but are not limited to, beta-butyrolactone, zeta-enantholactone, delta-valerolactone. Also, $C_1$-$C_6$ alkyl-substituted lactones, such as the alkyl delta-valerolactones, such as methyl-, ethyl-, hexyl-, dimethyl-, diethyl-, di-n-propyl-, di-n-hexyl-, di-iso-propyl-, trimethyl-, triethyl-, and tri-n-propyl-epsilon caprolactones, as well as $C_1$-$C_6$ alkoxy- and aromatic-substituted lactones may also be used.

The oligomer thus formed is hydroxy-terminated at the terminus opposite the (meth)acrylate functionality. Subsequently, the hydroxy-terminated (meth)acrylate oligomer is reacted with a polyfunctional isocyanate used in forming I' in the above formula by a conventional urethane addition polymerization procedure, to produce a (meth)acrylate-functional urethane oligomer component.

In the urethane reaction, the conditions are chosen so that the hydroxy terminal functionality of the (meth) acrylate functional oligomer reacts with all of the isocyanate functionalities present in I', to end-cap each of the isocyanate groups with T.

A preferred method for forming of urethane oligomers where q≥1 is to initially react an isocyanate with an alcohol by a conventional addition polymerization procedure, to form a polyisocyanate/polyol adduct represented by the formula $I'—(P'—I')_q$. Reaction conditions are chosen to form an isocyanate-terminated urethane oligomer to the virtual exclusion of alcohol-terminated polymeric materials. The optional incorporation of the $(P'—I')_q$ group into the urethane oligomer of formula III allows the oligomer to be tailored to particular applications. Subsequently, the isocyanate-terminated adduct is reacted with the hydroxy-terminated (meth)acrylate oligomer T defined above. The process described above is disclosed in U.S. 6,322,951 B1, the entire disclosure of which is hereby incorporated herein its entirety by reference.

Examples of suitable alcohols include, but are not limited to, monomeric or polymeric diols, such as ethylene glycol, propylene glycol, 1,4-butanediol, 2-ethyl-1,6-hexanediol, 1,10-decanediol, 1,4-bis-hydroxymethylcyclohexane, diethylene glycol, triethylene glycol, polyethylene glycols having molecular weights (MW) from about 200 to 1,500, the reaction products of 4,4'-dihydroxydiphenyl ether, 4,4'-dihydroxydiphenyl sulfide, 4,4'-dihydroxydiphenyl methane, 4,4'-dihydroxydiphenylpropane or 4,4'-dihydroxydiphenylsulfone with 0 to 40 moles of alkylene oxide, polypropylene glycols, polytetrahydrofuran, polybutylene glycols, thioethylene glycol and dithiotriethylene glycol; polyester polyols, such as polycaprolactone, polybutyrolactone, polyethylene terephthalate, polypropylene adipate, polybutylene adipate, polyethylenebutylene sebacate, and other polyester polyols having molecular weights (MW) in the range of about 250 to 3,000. Apart from the diols, monomer or polymeric compounds having 2 to 6 aliphatic hydroxy groups, such as glycerol, trimethylolpropane, pentaerythritol, dipentaerythritol, sorbitol, or polyalkoxylate derivatives of these; polymeric polyester polyols including the lactone polyesters; block copolymers of polyethers and polyesters having terminal hydroxy groups; and, caprolactone polyols and polysiloxane polyols, or the like. Other polyfunctional alcohols which contain acidic groups may also be used, including those described in U.S. Pat. No. 5,415,972, the entire disclosure of which is hereby incorporated herein its entirety by reference.

Through use of the above-described (meth)acrylate-functional urethane oligomer of formula III where the chain which links the (meth)acrylate functionality to the urethane group is extended with at least two alkylene oxide groups and at least one ring-opened lactone group, improved flexibility and tenting strength of the cross-linked system is achieved. The flexibility is achieved by incorporation of a long chain attached to the crosslinkable ethylenically unsaturated (meth)acrylate functionality. Coupled with improved flexibility, the urethane oligomer of formula III improves the adhesive properties of the resist to the copper clad surface of blank circuit board following lamination. Better adhesion enables the production of a fine line (less than 75 microns) resist sidewall that adheres better to the copper surface of the circuit board.

An improvement is seen in stripping and chemical resistance to processing solutions. Because the urethane oligomer of formula III produces better adhesion, stripping the resist from the copper surface would be expected to be more difficult. While not wishing to be bound by any particular theory, it is believed that by distancing the (meth)acrylate functionality from the urethane block with not only flexible alkylene oxide groups but also durable and high modulus ring-opened lactone groups, the ester links present in the ring-opened lactone portion provide sites for hydroxide attack during the stripping operation, thereby greatly shortening stripping time. While producing sites for stripping solution attack, the relatively hydrophobic chain extension also provides good chemical resistance to alkaline developing solution, acid plating baths and acid etching solutions.

In another embodiment, R may be a group derived from an oligomer with isocyanate derived pendent functional groups. The functionalized oligomer has a main chain or backbone that is derived from ethylenically or acetylenically unsaturated polymerizable monomers, and at least one monomer employed to make the oligomer backbone has a group that is free to react with the isocyanate group of an isocyanate compound to join the isocyanate compound to the oligomer backbone to form a pendent functional group. At least one pendent functional group terminates in one or more $\alpha,\beta$-ethylenically or acetylenically unsaturated group. Isocyanates includes monoisocyanates, diisocyanates, triisocyanates, and polyisocyanates. Such isocyanates include aliphatic, alicyclic, aromatic as well as heterocyclic isocyanate compounds.

The isocyanate derived oligomers may be prepared by a post polymerization functionalization process. In post polymerization functionalization, the main chain or backbone of the oligomer and the isocyanate derived functional pendent components are prepared separately. After the preparation of each of the separate components that make up the oligomer, they are then joined together in a separate reaction process to form the final functionalized oligomer product. The process is described below.

The main chain or backbone of the isocyanate functionalized oligomers may be derived from monomers which include, but are not limited to, acid functional monomers, base functional monomers, water soluble functional monomers or mixtures thereof. Examples of suitable ethylenically or acetylenically unsaturated monomers include, but are not limited to: (meth)acrylic acid, (meth)acrylamides, alkyl (meth)acrylates, alkenyl (meth)acrylates, aromatic (meth)acrylates, vinyl aromatic monomers, nitrogen-containing compounds and their thio-analogs, substituted ethylene monomers, cyclic olefins, substituted cyclic olefins, and the like. Preferred monomers include (meth)acrylic acid, alkyl (meth) acrylates and vinyl aromatic monomers. The backbone may be prepared by free radical polymerization or other suitable method.

After polymerization of monomers to form the oligomer backbone, the oligomer is reacted with free isocyanate groups, i.e., unreacted, of the isocyanate compounds. Free isocyanate, i.e., -N=C=O, reacts with a hydroxyl group from the polymer backbone, or a hydroxyl group from a carboxyl group from the polymer backbone to form a $R_6$-NH-C(O)-P" linkage where P" is the oligomer backbone, and $R_6$ is an organic pendent group from the isocyanate compound which may terminate in one or more ethylenically or acetylenically unsaturated moieties. A free isocyanate that reacts with a primary or secondary amine moiety joined to the polymer backbone forms a $R_6$-NH-C(O)-N$R_7$-G'-P" linkage where $R_7$ includes, but is not limited to, hydrogen, a linear, branched or unsubstituted or substituted alkyl, or an unsubstituted or substituted aryl. Substituent groups $R_7$ include, but are not limited to, halogen, such as fluorine, bromine, chloride or iodine, hydroxyl, carboxyl, or a primary or secondary amine. A substituent group replaces a hydrogen on a carbon atom. G' is an organic moiety that joins the nitrogen to the polymer chain. G' includes, but is not limited to, an alkyl, or a substituted aryl where the nitrogen is joined to the aryl by an alkyl chain. The alkyl chain of G' may be a linear or branched ($C_1$-$C_{24}$) alkyl. A free isocyanate that reacts with a polyalkoxylated moiety from the polymer backbone forms a $R_6$-NH-C(O)-O$(A_1O)_x$-C(O)-P" linkage where $A_1$ is a linear or branched ($C_1$-$C_{24}$)alkyl, and x is an integer from 0 to 1,000, preferably from 1 to 200.

The oligomer backbone is mixed with an isocyanate compound at reaction temperatures below 80° C. Preferably, reaction temperatures are run at mild temperatures of from 20° C to 60° C. Mixing and heating are continued until the reaction is complete. Typically, the reaction continues for about 1 hour to less than 8 hours, preferably from about 4 to about 6 hours. Advantageously, the method is performed over short time periods, thus less energy is utilized in preparing the functionalized oligomer. Reactions that take place occur between a free isocyanate group on the isocyanate compound and a hydroxyl group, carboxyl group, or primary or secondary aminyl functional group attached to the oligomer main chain or backbone. One mole of free isocyanate reacts with one mole of a hydroxyl, carboxyl, or primary or secondary aminyl on the oligomer main chain. The reaction may be self quenching. There is believed to be no source of free radicals, or a source of cations or anions at the end of the reaction between the isocyanate group(s) and hydroxyl, carboxyl, or aminyl group(s) on the oligomer backbone. As a precaution water, alcohol, or other chemical speicies with a labile hydrogen, and a suitable catalyst, such as triethylamine, may be added at the end of the reaction to quench any free isocyanate. Also, a suitable polymerization inhibitor may optionally be added to prevent premature cross-linking of terminal ethylenically or acetylenically unsaturated moieties such as a (meth)acrylate moiety. Reaction completion may be determined by using standard analytical instruments well known in the art.

The methods of making the functional oligomer may be carried out in the presence of an inert dry solvent, for example, an ether such as diisopropyl ether, ethylene glycol dimethyl ether, diethylene glycol dimethyl ether, 1,4-dioxane, tetrahydrofuran or 1,2-dimethoxy propane; an ester such as butyrolactone, ethylene glycol carbonate or propylene glycol carbonate; an ether ester such as methoxyethyl acetate, ethoxyethyl acetate, 1-methoxypropyl-2-acetate, 2-methoxypropyl-1-acetate, 1-ethoxypropyl-2-acetate or 2-ethoxypropyl-1-acetate; ketones such as acetone or methyethyl ketone; nitriles such as acetonitrile, propionitrile or methoxypropionitrile; sulfones such as sulfolane, dimethylsulfone or diethylsulfone; and phosphoric acid esters such as trimethyl phosphate or triethyl phosphate. The processes may also be carried out without such solvents.

$R_6$ as described above is the isocyanate compound less the free isocyanate group that reacts with a functional group of the oligomer backbone, i.e., hydroxyl, carboxyl or aminyl group. Examples of such compounds include, but are not limited to, the following general formulas:

$$O{=}C{=}N\text{-}Z\text{-}NH\text{-}C(O)\text{-}O\text{-}Y\text{-}O\text{-}C(O)\text{-}CR_8{=}CH_2;$$

$$O{=}C{=}N\text{-}Z\text{-}N[\text{-}C(O)\text{-}NH\text{-}Z\text{-}N\text{-}C(O)\text{-}O\text{-}Y\text{-}O\text{-}C(O)\text{-}CR_8{=}CH_2]_2;$$

or

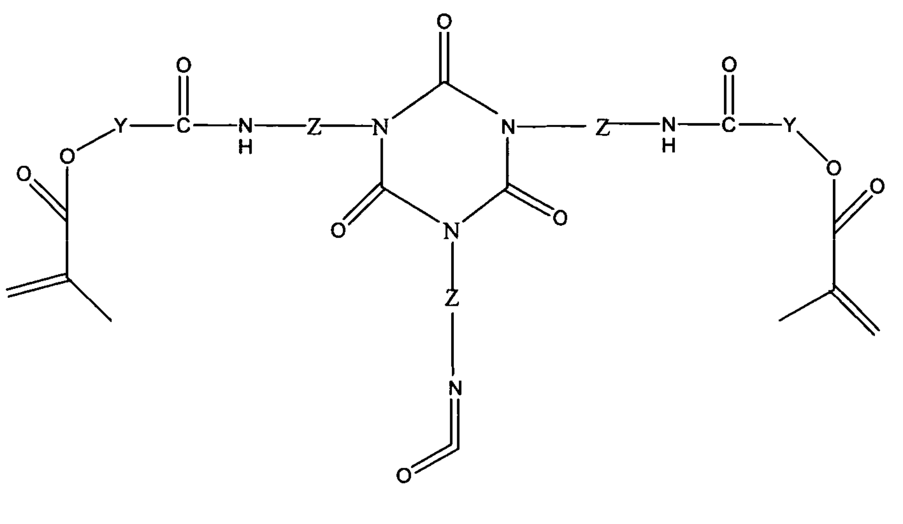

where Z includes, but is not limited to, alkyl, alkylene, cycloalkyl, aryl, heterocyclic alkyl, heteroaryl, a polymer such as a copolymer including a branched polymer or branched copolymer; Y includes, but is not limited to, alky, alkylene, cycloalkyl, aryl, heterocyclic alkyl, heteroaryl, $-((CH_2)_r-O-)_v-(CH_2)_w-$, or $-((CH_2)_r-C(O)-O-)_v-(CH_2)_w-$, where r, and w are integers of from 1 to 10, and v is an integer of from 0 to greater than 1,000, preferably from 1 to 200, most preferably from 5 to 10. $R_8$ is hydrogen or $(C_1-C_4)$ alkyl. Preferably $R_8$ is hydrogen or methyl. Heteroatoms include, but are not

limited to, oxygen, sulfur, and nitrogen. The alkyl, alkylene, cycloalkyl, aryl, heterocyclic alkyl, heteroaryl and polymers may be unsubstituted or substituted. Examples of suitable substitutent groups include, but are not limited to, carboxyl, hydroxyl, ($C_1$-$C_4$) alkyl, aminol such as a primary or secondary aminol, or hydroxyaminol, or -CN.

Examples of suitable alkyl groups include, but are not limited to, linear or branched ($C_1$-$C_{20}$) alkyl. Examples of alkenyl, cycloakyl or aryl groups include, but are not limited to, linear or branched ($C_2$-$C_{20}$) alkenyl, ($C_5$-$C_6$) cycloalky such as an isophorone, and ($C_5$-$C_6$) aryl such as phenyl.

The isocyanate compounds with at least one free isocyanate group may be prepared by any suitable method known in the art. Diisocyanates or triisocyanates that may be employed are either known or may be prepared by analogy to known compounds. Examples of suitable diisocyanates and triisocyanates include, but are not limited to, ethylene diisocyanate, propylene diisocyanate, butylene-1,3-diisocyanate, 1,6-hexamethylene diisocyanate, 2,2,4-trimethyl-hexamethylene diisocyanate, 2,4-dimethyl-6-ethyloctamethylene diisocyanate, cyclohexylene diisocyanate, cyclopentylene diisocyanate, 1,4-diisocyanatomethyl-cyclohexane, 1,3-diisocyanatoethyl-cyclohexane, toluylene diisocyanate, 3,3,5-trimethyl-1-isocyanato-5-isocyanatomethyl-cyclohexane, 2-butene-1,4-diisocyanate, isophorone diisocyanate, 1,6-hexamethylene diisocyanate biuret, 1,6-hexamethylene diisocyanate trimer, isophorone diisocyanate trimer, bis phenol A dimethacrylate capped with 2-hydroxethylmethacrylate capped with 1,6-hexamethylene diisocyanate trimer, and the like. Many of the foregoing listed diisocyantes and triisocyantes as well as the biurets and trimers may be purchased from Lyondell (located at 122 Melanney St., Houston, TX) or Bayer (located at 100 Bayer Rd., Pittsburgh, PA 15025).

Isocyanates such as the diisocyanates and triisocyanates described above may then be reacted with a sufficient amount of one or more hydroxyl containing compounds such that at least one free isocyanate group is left to react with the main chain or backbone of the oligomer prepared as described above. The reaction mole ratio of hydroxyl group to isocyanate group is about 1:1. The process of addition of alcohols to isocyanates is well known in the art. Any suitable compound with at least one free hydroxyl group to react with an isocyanate group may be employed. An isocyanate compound also may be reacted with a second isocyanate compound having at least one free hydroxyl group. Hydroxyalkyl, hydroxyalkenyl, hydroxyaryl compounds and the like are examples of such compounds that may be employed. Hydroxyalkyl (meth)acrylates are one example of suitable compounds. Hydroxyethyl (meth)acrylate or hydroxypropyl (meth)acrylate (n- or iso-compounds) are examples of hydroxyl group-containing esters that are suitable. Other suitable hydroxyalkyl (meth)acrylates include, but are not limited to, 2-hydroxy-butyl (meth)acrylate, 4-hydroxybutyl (meth)acrylate, 2-hydroxy-cyclohexyl (meth)acrylate, 2-hydroxyethylmethacrylate, and the like. Suitable polyethylene glycol mono (meth)acrylates also may be employed such as, but not limited to, diethylene glycol mono (meth) acrylate, triethylene glycol mono (meth)acrylate and the like. Hydroxyalicyclic (meth)acrylates, and hydroxyaromatic (meth)acrylates such as bis phenol A dimethacrylate also may be employed.

Acetoacetate derivatives and acrylates which react in a Michael addition reaction to form oligomers having a built-in photoiniator may be prepared by any suitable method known in the art. Acetoacetates or diketones may be prepared by reacting esters together with the desired R' and R" radicals using known organic chemistry procedures. The esters may be prepared from their corresponding organic acids by reacting the acids with alcohols. An alternative method involves reacting an ester with a ketone in the presence of an alcoholate of which the alcohol is volatile under the conditions of operation. The specific process is disclosed in U.S. 5,475,145, the entire disclosure of which is hereby incorporated herein in its entirety by reference. A method for preparing aromatic diketones is disclosed in U.S. 5,015,777, the entire disclosure of which is hereby incorporated herein in its entirety by reference.

Acrylates containing desired R groups may be prepared by reacting an acrylic acid with an alcohol containing the desired R group. For example, an acrylic acid may react with a diol of the compound containing the R group in an esterification reaction to form ester bonds with the R group, thus forming a diacrylate. The diacrylate may then be reacted with the acetoacetate derivative in a Michael addition reaction to form the free-radical generating oligomer such as the oligomer of formula I above.

As mentioned above, the hydrophilic compounds which generate a free-radical of the present invention are water-soluble or water-emulsifiable. Water-soluble within the scope of the present invention means that the hydrophilic compound forms a solution of greater than 0.1% by weight, preferably greater than 1.0% by weight and more preferably greater than 90% by weight. Most preferably the hydrophilic compound may form an aqueous solution of from 90% to 95% by weight. Water-emulsifiable means that the hydrophilic compound forms an aqueous composition of dispersed particles in amounts of greater than 0.1 % by weight, preferably greater than 1.0% by weight, and more preferably greater than 90% by weight. Most preferably the dispersed particles of the hydrophilic compound are 90% to 95% by weight of the aqueous composition. Aqueous compositions also include basic aqueous compositions such as developer and stripper solutions. However, when a photoresist including a hydrophilic compound of the present invention is cured, solubility or emulsifiability is reduced to below 0.1 % by weight.

The photoresists of the present invention compose from 25% by weight to 95% by weight, preferably from 50% to 95% by weight, of the free-radical generating compound. The remaining weight is composed of conventional photoresist additives such as optional photoinitiators, cross-linking agents, inert fillers, dyes, strippers or mixtures

thereof. Specific amounts of the conventional additives may be added in amounts to tailor the photoresist composition to desired performance.

Because the hydrophilic compound which generates a free-radical is self-cross-linking, the compound may perform as the only cross-linking agent in the photoresist, or may perform as the only binder in the photoresist. If additional binders are employed, the compound which generates a free-radical may compose from 25% by weight to 80% by weight. The additional binders may compose from 10% to 30% by weight of the photoresist. The balance of the photoresist is composed of conventional components described below. The conventional components may be added in amounts to taylor the photoresist to a desired performance.

A wide variety of optional polymeric binders are suitable to practice the present invention. Suitable polymeric binders are generally commercially available from a variety of sources, such as Rohm and Haas Company (Philadelphia, Pennsylvania) or may be prepared by a variety of methods known in the literature. Mixtures of binders may be employed to practice the present invention. The binders may be mixed in any suitable ratio.

An example of suitable polymeric binders are those containing as polymerized units one or more ethylenically or acetylenically unsaturated monomers and one or more difunctional branch-point monomers having two polymerizable end groups and a backbone including one or more base cleavable functionalities. Suitable ethylenically or acetylenically unsaturated monomers include, but are not limited to: (meth)acrylic acid, (meth)acrylamides, alkyl (meth) acrylates, alkenyl (meth)acrylates, aromatic (meth)acrylates, vinyl aromatic monomers, nitrogen-containing compounds and their thio-analogs, substituted ethylene monomers, cyclic olefins, substituted cyclic olefins, and the like. Preferred monomers include (meth)acrylic acid, alkyl (meth)acrylates and vinyl aromatic monomers.

Typically, the alkyl (meth)acrylates useful in the present invention are ($C_1$-$C_{24}$)alkyl (meth)acrylates. Suitable alkyl (meth)acrylates include, but are not limited to, "low cut" alkyl (meth)acrylates, "mid cut" alkyl (meth)acrylates and "high cut" alkyl (meth)acrylates.

"Low cut" alkyl (meth)acrylates are typically those where the alkyl group contains from 1 to 6 carbon atoms. Suitable low cut alkyl (meth)acrylates include, but are not limited to: methyl methacrylate, methyl acrylate, ethyl acrylate, propyl methacrylate, butyl methacrylate, butyl acrylate, isobutyl methacrylate, hexyl methacrylate, cyclohexyl methacrylate, cyclohexyl acrylate and mixtures thereof.

"Mid cut" alkyl (meth)acrylates are typically those where the alkyl group contains from 7 to 15 carbon atoms. Suitable mid cut alkyl (meth)acrylates include, but are not limited to: 2-ethylhexyl acrylate ("EHA"), 2-ethylhexyl methacrylate, octyl methacrylate, decyl methacrylate, isodecyl methacrylate (based on branched ($C_{10}$)alkyl isomer mixture), undecyl methacrylate, dodecyl methacrylate (also known as lauryl methacrylate), tridecyl methacrylate, tetradecyl methacrylate (also known as myristyl methacrylate), pentadecyl methacrylate and mixtures thereof. Particularly useful mixtures include dodecyl-pentadecyl methacrylate, a mixture of linear and branched isomers of dodecyl, tridecyl, tetradecyl and pentadecyl methacrylates; and lauryl-myristyl methacrylate.

"High cut" alkyl (meth)acrylates are typically those where the alkyl group contains from 16 to 24 carbon atoms. Suitable high cut alkyl (meth)acrylates include, but are not limited to: hexadecyl methacrylate, heptadecyl methacrylate, octadecyl methacrylate, nonadecyl methacrylate, cosyl methacrylate, eicosyl methacrylate and mixtures thereof. Particularly useful mixtures of high cut alkyl (meth)acrylates include, but are not limited to: cetyl-eicosyl methacrylate, which is a mixture of hexadecyl, octadecyl, cosyl and eicosyl methacrylate; and cetyl-stearyl methacrylate, which is a mixture of hexadecyl and octadecyl methacrylate.

The mid-cut and high-cut alkyl (meth)acrylate monomers described above are generally prepared by standard esterification procedures using technical grades of long chain aliphatic alcohols, and these commercially available alcohols are mixtures of alcohols of varying chain lengths containing between 10 and 15 or 16 and 20 carbon atoms in the alkyl group. Examples of these alcohols are the various Ziegler catalyzed ALFOL alcohols from Vista Chemical company, i.e., ALFOL 1618 and ALFOL 1620, Ziegler catalyzed various NEODOL alcohols from Shell Chemical Company, i.e. NEODOL 25L, and naturally derived alcohols such as Proctor & Gamble's TA-1618 and CO-1270. Consequently, for the purposes of this invention, alkyl (meth)acrylate is intended to include not only the individual alkyl (meth) acrylate product named, but also to include mixtures of the alkyl (meth)acrylates with a predominant amount of the particular alkyl (meth)acrylate named.

The alkyl (meth)acrylate monomers useful in the present invention may be a single monomer or a mixture having different numbers of carbon atoms in the alkyl portion. Also, the (meth)acrylamide and alkyl (meth)acrylate monomers useful in the present invention may optionally be substituted. Suitable optionally substituted (meth)acrylamide and alkyl (meth)acrylate monomers include, but are not limited to: hydroxy($C_2$-$C_6$)alkyl (meth)acrylates, dialkylamino($C_2$-$C_6$)-alkyl (meth)acrylates, dialkylamino($C_2$-$C_6$)alkyl (meth)acrylamides.

Other substituted (meth)acrylate and (meth)acrylamide monomers useful in the present invention are those with a dialkylamino group or dialkylaminoalkyl group in the alkyl radical. Examples of such substituted (meth)acrylates and (meth)acrylamides include, but are not limited to: dimethylaminoethyl methacrylate, dimethylaminoethyl acrylate, N,N-dimethylaminoethyl methacrylamide, N,N-dimethyl-aminopropyl methacrylamide, N,N-dimethylaminobutyl methacrylamide, N,N-di-ethylaminoethyl methacrylamide, N,N-diethylaminopropyl methacrylamide, N,N-diethylaminobutyl

methacrylamide, N-(1,1-dimethyl-3-oxobutyl) acrylamide, N-(1,3-diphenyl-1-ethyl-3-oxobutyl) acrylamide, N-(1-methyl-1-phenyl-3-oxobutyl) methacrylamide, and 2-hydroxyethyl acrylamide, N-methacrylamide of aminoethyl ethylene urea, N-methacryloxy ethyl morpholine, N-maleimide of dimethylaminopropylamine and mixtures thereof.

Other substituted (meth)acrylate monomers useful in the present invention are silicon-containing monomers such as γ-propyl tri($C_1$-$C_6$)alkoxysilyl (meth)acrylate, γ-propyl tri($C_1$-$C_6$)alkylsilyl (meth)acrylate, γ-propyl di($C_1$-$C_6$) alkoxy($C_1$-$C_6$)alkylsilyl (meth)acrylate, γ-propyl di($C_1$-$C_6$)alkyl($C_1$-$C_6$)alkoxysilyl (meth)acrylate, vinyl tri($C_1$-$C_6$)alkoxysilyl (meth)acrylate, vinyl di($C_1$-$C_6$)alkoxy($C_1$-$C_6$)alkylsilyl (meth)acrylate, vinyl ($C_1$-$C_6$)alkoxydi($C_1$-$C_6$)alkylsilyl (meth)acrylate, vinyl tri($C_1$-$C_6$)alkylsilyl (meth)acrylate, 2-propylsilsesquioxane (meth)acrylate and mixtures thereof.

The vinyl aromatic monomers useful as unsaturated monomers in the present invention include, but are not limited to: styrene, hydroxystyrene, α-methylstyrene, vinyltoluene, *p*-methylstyrene, ethylvinylbenzene, vinylnaphthalene, vinylxylenes, and mixtures thereof. The vinylaromatic monomers also include their corresponding substituted counterparts, such as halogenated derivatives, i.e., containing one or more halogen groups, such as fluorine, chlorine or bromine; and nitro, cyano, ($C_1$-$C_{10}$)alkoxy, halo($C_1$-$C_{10}$)alkyl, carb($C_1$-$C_{10}$)alkoxy, carboxy, amino, ($C_1$-$C_{10}$)alkylamino derivatives and the like.

The nitrogen-containing compounds and their thio-analogs useful as unsaturated monomers in the present invention include, but are not limited to: vinylpyridines such as 2-vinylpyridine or 4-vinylpyridine; ($C_1$-$C_8$)alkyl substituted N-vinyl pyridines such as 2-methyl-5-vinyl-pyridine, 2-ethyl-5-vinylpyridine, 3-methyl-5-vinylpyridine, 2,3-dimethyl-5-vinyl-pyridine, and 2-methyl-3-ethyl-5-vinylpyridine; methyl-substituted quinolines and isoquinolines; N-vinylcaprolactam; N-vinylbutyrolactam; N-vinylpyrrolidone; vinyl imidazole; N-vinyl carbazole; N-vinyl-succinimide; (meth)acrylonitrile; *o*-, *m-,* or *p*-aminostyrene; maleimide; N-vinyl-oxazolidone; N,N-dimethyl aminoethyl-vinyl-ether; ethyl-2-cyano acrylate; vinyl acetonitrile; N-vinylphthalimide; N-vinyl-pyrrolidones such as N-vinyl-thio-pyrrolidone, 3 methyl-1-vinyl-pyrrolidone, 4-methyl-1-vinyl-pyrrolidone, 5-methyl-1-vinyl-pyrrolidone, 3-ethyl-1-vinyl-pyrrolidone, 3-butyl-1-vinyl-pyrrolidone, 3,3-dimethyl-1-vinyl-pyrrolidone, 4,5-dimethyl-1-vinyl-pyrrolidone, 5,5-dimethyl-1-vinyl-pyrrolidone, 3,3,5-trimethyl-1-vinyl-pyrrolidone, 4-ethyl-1-vinyl-pyrrolidone, 5-methyl-5-ethyl-1-vinyl-pyrrolidone and 3,4,5-trimethyl-1-vinyl-pyrrolidone; vinyl pyrroles; vinyl anilines; and vinyl piperidines.

The substituted ethylene monomers useful as unsaturated monomers is in the present invention include, but are not limited to: vinyl acetate, vinyl formamide, vinyl chloride, vinyl fluoride, vinyl bromide, vinylidene chloride, vinylidene fluoride, vinylidene bromide, tetrafluoroethylene, trifluoroethylene, trifluoromethyl vinyl acetate, vinyl ethers and itaconic anhydride.

Suitable cyclic olefin monomers useful in the present invention are ($C_5$-$C_{10}$)cyclic olefins, such as cyclopentene, cyclopentadiene, dicylopentene, cyclohexene, cyclohexadiene, cycloheptene, cycloheptadiene, cyclooctene, cyclooctadiene, norbornene, maleic anhydride and the like. Such cyclic olefins also include spirocyclic olefin monomers such as spirocyclic norbornenyl monomers, spirocyclic cyclohexene monomers, spirocyclic cyclopentene monomers and mixtures thereof. Suitable substituted cyclic olefin monomers include, but are not limited to, cyclic olefins having one or more substituent groups selected from hydroxy, aryloxy, halo, ($C_1$-$C_{12}$)alkyl, ($C_1$-$C_{12}$)haloalkyl, ($C_1$-$C_{12}$)hydroxyalkyl, ($C_1$-$C_{12}$)halohydroxyalkyl such as $(CH_2)_{n'}C(CF_3)_2OH$ where n' = 0 to 4, ($C_1$-$C_{12}$)alkoxy, thio, amino, ($C_1$-$C_6$) alkylamino, ($C_1$-$C_6$)dialkylamino, ($C_1$-$C_{12}$)alkylthio, carbo($C_1$-$C_{20}$)alkoxy, carbo($C_1$-$C_{20}$)haloalkoxy, ($C_1$-$C_{12}$)acyl, ($C_1$-$C_6$)alkylcarbonyl($C_1$-$C_6$)alkyl, and the like. Particularly suitable substituted cyclic olefins include maleic anhydride and cyclic olefins containing one or more of hydroxy, aryloxy, ($C_1$-$C_{12}$)alkyl, ($C_1$-$C_{12}$)haloalkyl, ($C_1$-$C_{12}$)hydroxyalkyl, ($C_1$-$C_{12}$)halohydroxyalkyl, carbo($C_1$-$C_{20}$)alkoxy, and carbo($C_1$-$C_{20}$)haloalkoxy. It will be appreciated by those skilled in the art that the alkyl and alkoxy substituents may be optionally substituted, such as with halogen, hydroxyl, cyano, ($C_1$-$C_6$)alkoxyl, mercapto, ($C_1$-$C_6$)alkylthio, amino, and the like.

Any of a wide variety of difunctional branch-point monomers are suitable for use in preparing the branched binder polymers of the present invention provided that such branch-point monomers contain a backbone comprising one or more base cleavable functionalities or moieties, where such functionalities are disposed between the polymerizable groups of the branch-point monomer. By "base cleavable functionality" is meant any functionality or group that can be cleaved by a base such as hydroxide ion, alkoxide ion, ammonia, amines and the like.

A wide variety of difunctional branch-point monomers containing base cleavable moieties may be used in the present invention. In general, such branch-point monomers have the structure

A'-Z'-B'

where A' and B' each include one or more polymerizable groups, and Z' includes one or more base cleavable groups. Suitable polymerizable groups for A' and B' include, but are not limited to, isocyanate ("-NCO"), $R_{10}R_{11}C=CR$-, $R_{10}$-C=C-, $R_{10}R_{11}C=CR_{12}C(O)$-O-, $R_{10}R_{11}C=CR_{12}$-O-, and -C(O)-O-$R_9$; wherein $R_{10}$, $R_{11}$ and $R_{12}$ are independently selected from H, ($C_1$-$C_4$)alkyl and halo; $R_9$ is selected from H, ($C_1$-$C_4$)alkyl, and $NR_{13}R_{14}$; and $R_{13}$ and $R_{14}$ are independently selected from H and ($C_1$-$C_4$)alkyl. In addition to one or more base cleavable groups, the group Z' may

optionally include one or more spacer groups. Z' may suitably have the general formula $S_x(BCG)_y$; wherein S is a spacer group; (BCG) is a base cleavable group; x = 0-20 and y = 1-30. It is preferred that y = 2-20. Suitable spacer groups include, but are not limited to, alkyleneoxy, aryleneoxy, $(C_1-C_{20})$alkylene, substituted$(C_1-C_{20})$alkylene, $(C_6-C_{20})$ aralkylene, substituted $(C_6-C_{20})$aralkylene, and the like. Suitable alkyleneoxy groups have the general formula $(-CHR_{15}-CH_2O-)_n$, $(-OCHR_{15}-CH_2-)_m$, or $(-O-CH_2-CH_2-CH_2-)_p$, where $R_{15}$ is H or $CH_3$, and n, m and p are each 1-1000. Exemplary alkylenoxy groups include ethyleneoxy, propyleneoxy and ethyleneoxy/propyleneoxy mixtures. Aryleneoxy or arylene ether spacers include phenyleneoxy (phylene ether) spacers having the general formula $(-C_6H_4-O-)_z$ where z = 1-1000, biphenylene ethers, phenanthryl ethers, naphthyl ethers, and mixtures thereof. When two or more spacer groups are used, they may be the same or different.

"Substituted alkyl" refers to any alkyl group having one or more of its hydrogens replaced by another substituent group selected from halo, cyano, hydroxyl, $(C_1-C_8)$alkoxy, amino, $(C_1-C_6)$alkylamino, di$(C_1-C_6)$alkylamino, phenyl, carb$(C_1-C_6)$alkoxy, and the like. Likewise, "substituted aralkyl" refers to any aralkyl group having one or more of its hydrogens replaced by another substituent group selected from halo, cyano, hydroxyl, $(C_1-C_8)$alkoxy, amino, $(C_1-C_6)$ alkylamino, di$(C_1-C_6)$alkylamino, phenyl, carb$(C_1-C_6)$alkoxy, and the like.

Such spacer groups may be selected to provide additional properties. For example, alkyleneoxy spacers, such as ethyleneoxy and/or propyleneoxy moieties, may help to emulsify the polymeric binders for use in water borne photoresists. Spacers having extended chain length may also provide improved flexibility and be particularly useful in conformal photoresist formulations. The choice of such spacer groups will depend upon the particular use of the polymer and the other components in the formulation, and is within the ability of one skilled in the art.

Any base cleavable group is suitable for use in Z', but is preferably selected from anhydrides (-C(O)-O-(O)C-), esters (-C(O)-O-), carbonates, sulfonyl esters $(-SO_2-O-)$ and the like, and more preferably esters. It is more preferred that the difunctional branch-point monomers contain 2 or more base cleavable groups and still more preferably 3 or more base cleavable groups. Particularly suitable difunctional branch-point monomers contain 4 base cleavable groups, and more particularly 4 or more ester linkages. It is further preferred that the difunctional branch point monomer contain as polymerizable end groups moieties that also contain one or more base cleavable functionalities, such as (meth)acrylate esters. When the difunctional branch-point monomers contain 2 or more base cleavable groups, such groups may be directly bonded to each other or may be separated by one or more spacer groups. An exemplary structure for such branch-point monomers having multiple base cleavable groups is $A'-(S1)_{x1}-(BCG)1-(S2)_{x2}-(BCG)2-(S3)_{x3}-B'$, wherein S1, S2 and S3 refer to spacer groups 1-3, respectively, (BCG)1 and (BCG)2 refer to base cleavable groups 1 and 2, respectively, x1 + x2 + x3 = 0-20, and A', B', S, (BCG) and B' are as defined above. Other suitable structures having more or fewer spacers and/or base cleavable groups or different configurations of such groups are well within the ability of those skilled in the art.

Suitable difunctional branch-point monomers useful in preparing the branched binder polymers of the present invention include, but are not limited to, acrylic anhydride, methacrylic anhydride, and ester linkage containing monomers having (meth)acrylate end groups. Exemplary difunctional branch-point monomers including one or more urethane linkages and having (meth)acrylate end groups are: pdmbi-pcp0200-pdmbi, pdmbi-pcp0201-pdmbi, pdmbi-pcp0230-pdmbi, eh6cl4-hdi-ppg1000-hdi-eh6cl4, eh6cl4-hdi-pcp0230-hdi-eh6cl4, eh6cl4-hdi-ppg425-hdi-dmpa-hdi-ppg425-hdi-eh6cl4, 2hema-hdi-pcp0230-hdi-ppg425-hdi-pcp0230-hdi-2hema, 2hema-hdi-pcp0230-hdi-peg400-hdi-pcp0230-hdi-2hema, 2hema-hdi-pcp0200-hdi-pcp0230-hdi-pcp0200-hdi-2hema, e6hem-hdi-pcp0200-hdi-pcp0230-hdi-pcp0200-hdi-e6hem, e6hem-hdi-pcp0200-hdi-ppg1000-hdi-pcp0200-hdi-e6hem, e6hem-hdi-ppg425-hdi-pcp0230-hdi-ppg425-hdi-e6hem, e6hem-hdi-ppg1000-hdi-pcp0230-hdi-ppg1000-hdi-e6hem, e6hem-hdi-pcp0230-hdi-ppg425-hdi-pcp0230-hdi-e6hem, and e6hem-hdi-ppg 1000-hdi-pcp0201-hdi-ppg1000-hdi-e6hem. In the above described difunctional branch-point monomers, each "dash" represents a urethane group (formed when an isocyanate group reacts with a hydroxyl group) between the adjacent moieties. Such urethane linkages are not required in the present branch-point monomers. The abbreviations for the moieties are: hdi = 1,6-hexamethylene diisocyanate; pcp0200 = TONE™ Polyol 0200 Diol (containing carboxylic ester groups); pcp0201 = TONE™ Polyol 0201 Diol (contains carboxylic ester groups); pcp0230 = TONE™ Polyol 0230 Diol (contains carboxylic ester groups); ppg425 = polypropylene glycol having a molecular weight of approximately 425; ppg1000 = polypropylene glycol having a molecular weight of approximately 1000; dmpa = dimethylolpropionic acid; pdmbi = 3-isopropenyl-alpha,alpha-dimethylbenzyl isocyanate; 2hema = 2-hydroxyethyl methacrylate (contains ester group and a polymerizable end group); e6hem = ethoxylated hydroxyethyl methacrylate (contains ester group and a polymerizable end group); and eh6cl4 = ethoxylated caprolactone-derived methacrylate (contains ester groups and a polymerizable end group). Such branch-point monomers are generally commercially available or may be readily prepared by known methods. TONE™ is a trademark for polycaprolactone diols, available from the Dow Chemical Company (Midland, Michigan). Other suitable polycaprolactone diols are available from Solvay under the CAPA brand name. Typically, the molecular weight of the branch-point monomers is ≥ 450, and preferably from 450 to 6000.

The branched polymeric binders of the present invention include as polymerized units one or more difunctional branch-point monomers having two polymerizable end groups and a backbone including one or more base cleavable functionalities. When polymeric binders are prepared from tri-, tetra- or higher-functional branch-point monomers, i.e.

those containing 3 or more polymerizable end groups, such polymeric binders are much more likely to suffer from gel formation, which makes such binders unsuitable for use in photoresist compositions. Further, when polymeric binders are prepared from relatively low molecular weight, i.e. < 450, difunctional branch-point monomers containing no urethane linkages and containing (meth)acrylate esters as both polymerizable end groups, such polymeric binders also suffer from gel formation. Such gel formation is not a problem when the difunctional branch-point monomers are higher molecular weight, i.e. ≥ 450, monomers containing (meth)acrylate esters as both polymerizable end groups, or when such monomers contain one or more urethane linkages.

The present invention further provides a compound having the formula A'-Z'-B' wherein A' and B' each include one or more polymerizable groups and Z' includes one or more base cleavable groups.

More than one difunctional branch-point monomer may be used to prepare the branched binder polymers. Thus, mixtures of difunctional branch-point monomers may advantageously be used in the present invention. Typically, the total amount of such difunctional branch-point monomers in the branched binder polymers is from 0.1 to 100 wt% based upon the total weight of the monomers used to prepare the binder polymer, preferably from 0.1 to 25 wt%, and more preferably from 0.1 to 10 wt%.

The branched binder polymers may be prepared by a variety of methods known in the art, such as free radical polymerization. Preferably, the difunctional branched polymeric binders contain sufficient acid functionality to render the binder polymers soluble and removable upon development. The term "acid functionality" refers to any functionality capable of forming a salt upon contact with alkaline developer, such as dilute alkaline aqueous sodium or potassium hydroxide, e.g. 1 to 3 wt% solutions. Suitable acid functionality includes, but is not limited to, carboxylic acids, sulfonic acids, phosphonic acids and phenols. In general, the binder polymers have an acid number of up to about 250, preferably up to about 200. Typical ranges of acid numbers are from 15 to 250 and preferably from 50 to 250. Such acid numbers are based on the amount of KOH (potassium hydroxide) in mg to neutralize 1 g (dry weight) of binder polymer.

While the free-radical generating compounds of the present invention may be the only cross-linking agent in the photoresist, as discussed above, monomers may be added which polymerize into a network around the polymeric binders. A wide variety of monomers may be used. Suitable monomers include, but are not limited to: methyl acrylate, 2-ethylhexyl acrylate, n-butyl acrylate, n-hexyl acrylate, methyl methacrylate, hydroxyethyl acrylate, butyl methacrylate, octyl acrylate, 2-ethoxyethyl methacrylate, t-butyl acrylate, 1,5-pentanediol diacrylate, N,N-diethylaminoethyl acrylate, ethylene glycol diacrylate, 1,3-propanediol diacrylate, decamethylene glycol diacrylate, decamethylene glycol dimethacrylate, 1,4-cyclohexanediol diacrylate, 2,2-dimethylol propane diacrylate, glycerol diacrylate, tripropylene glycol diacrylate, glycerol triacrylate, 2,2-di(p-hydroxyphenyl)-propane dimethacrylate, triethylene glycol diacrylate, polyoxyethyl-2-2-di(p-hydroxyphenyl)-propane dimethacrylate, triethylene glycol dimethacrylate, polyoxypropyltrimethylol propane triacrylate, ethylene glycol dimethacrylate, butylene glycol dimethacrylate, 1,3-propanediol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, and 1,4-benzenediol dimethacrylate; styrene and substituted styrene, such as 2-methyl styrene and vinyl toluene and vinyl esters, such as vinyl acrylate and vinyl methacrylate. Such monomers may be included in conventional amounts.

Although the photoimageable compositions have hydrophilic free-radical generating compounds, photoimageable compositions of the present invention optionally may contain an additional photoactive component. Optional photoactive components useful in the present invention may be photoacid generators, photobase generators or free-radical generators. The present photoimageable compositions may be positive-acting or negative-acting, and preferably are negative-acting. Mixtures of photoactive components allow the photoactivity of the compositions to be tailored to specific applications.

Suitable photoacid generators include halogenated triazines, onium salts, sulfonated esters, halogenated sulfonyloxy dicarboximides, diazodisulfones, $\alpha$-cyanooxyaminesulfonates, imidesulfonates, ketodiazosulfones, sulfonyldiazoesters, 1,2-di(arylsulfonyl)hydrazines and the like. Particularly useful halogenated triazines include halomethyl-s-triazines.

Suitable free-radical generators include, but are not limited to, n-phenylglycine, aromatic ketones such as benzophenone, N, N'-tetramethyl-4, 4'-diaminobenzophenone [Michler's ketone], N,N'-tetraethyl-4,4'-diaminobenzophenone, 4-methoxy-4'-dimethylaminobenzophenone, 3,3'-dimethyl-4-methoxybenzophenone, p,p'-bis(dimethylamino)benzophenone, p,p'-bis(diethylamino)-benzophenone, anthraquinone, 2-ethylanthraquinone, naphthaquinone and phenanthraquinone, benzoins such as benzoin, benzoinmethylether, benzoinethylether, benzoinisopropylether, benzoin-n-butylether, benzoin-phenylether, methylbenzoin and ethybenzoin, benzyl derivatives such as dibenzyl, benzyldiphenyldisulfide and benzyldimethylketal, acridine derivatives such as 9-phenylacridine and 1,7-bis(9-acridinyl)heptane, thioxanthones such as 2-chlorothioxanthone, 2-methylthioxanthone, 2,4-diethylthioxanthone, 2,4-dimethylthioxanthone and 2-isopropylthioxanthone, acetophenones such as 1,1-dichloroacetophenone, p-t-butyldichloro-acetophenone, 2,2-diethoxyacetophenone, 2,2-dimethoxy-2-phenylacetophenone, and 2,2-dichloro-4-phenoxyacetophenone, 2,4,5-triarylimidazole dimers such as 2-(o-chlorophenyl)-4,5-diphenylimidazole dimer, 2-(o-chlorophenyl)-4,5-di(m-methoxyphenyl imidazole dimer, 2-(o-fluorophenyl)-4,5-diphenylimidazole dimer, 2-(o-methoxyphenyl)-4,5-diphenylimidazole dimer, 2-(p-methoxyphenyl)-4,5-diphenylimidazole dimer, 2,4-di(p-methoxyphenyl)-5-phenylimidazole dimer, 2-(2,4-dimethoxyphenyl)-4,5-diphenylimidazole dimer and 2-(p-methylmercaptophenyl)-4,5-diphenylimidazole dimer, and the like. Though, not a free-radical generator, triphenylphosphine may be included in the photoactive chemical system as a catalyst. Such free-radical generators are particularly suitable for use with negative-acting photoimageable compositions, and particularly suitable for use with negative-acting dry film photoimageable compositions of the present invention.

Because the photoresists of the present invention have hydrophilic compounds which generate free-radicals which are integral to the compounds, optional photoactive components may be added in amounts from 0.1 to 5 wt%, and more preferably from 0.1 to 2 wt% of the photoresist.

The present photoimageable compositions may be solvent-borne or water-borne. Whether such compositions are solvent- or water-borne depends upon the choice of polymer binder, including the choice of monomers and difunctional branch-point monomers used to prepare the polymer binders. Such choices of monomers and difunctional branch-point monomers is well within the ability of one skilled in the art. Thus, the present photoimageable compositions may optionally contain water, a solvent or a water-solvent mixture. Suitable solvents include, but are not limited to: ketone solvents such as acetone, methyl ethyl ketone, cyclohexanone, methyl isoamyl ketone and 2-heptanone; polyhydric alcohols and derivatives thereof such as ethyleneglycol, ethyleneglycol monoacetate, diethyleneglycol, diethyleneglycol monoacetate, propyleneglycol, propyleneglycol monoacetate, dipropyleneglycol and dipropyleneglycol monoacetate as well as monomethyl, monoethyl, monopropyl, monobutyl and monophenyl ethers thereof; cyclic ether solvents such as dioxane; ester solvents such as methyl lactate, ethyl lactate, methyl acetate, ethyl acetate, butyl acetate, methyl pyruvate, ethyl pyruvate, methyl methoxypropionate and ethyl ethoxypropionate; and amide solvents such as N,N-dimethyl formamide, N,N-dimethyl acetamide, N-methyl-2-pyrrolidone, 3-ethoxyethyl propionate, 2-heptanone, γ-butyrolactone, and mixtures thereof.

Other optional additives that may be used in the present photoimageable compositions include, but are not limited to: plasticizers, rheology modifiers, speed enhancers, fillers, dyes, film forming agents, strip enhancers such as hydrophobic trihalomethyl containing photoresist strip enhancers or mixtures thereof. Suitable plasticizers include esters such as dibenzoate esters. Suitable hydrophobic trihalomethyl containing photoresist strip enhancers include a wide variety of compounds containing a trihalomethyl group which hydrolyzes to carboxylate anions during stripping of the photoresist. Preferably, such hydrophobic trihalomethyl containing photoresist strip enhancer is alpha-trichloromethyl benzyl acetate. Such optional additives may be present in various concentrations in a photoresist composition. For example, fillers and dyes may be used in relatively large concentrations, e.g. in amounts of from about 5 to 30 percent by weight, based on the total weight of the composition's dry components.

Photoresist compositions of the present invention may be prepared by combining the free-radical generating compounds of the present invention with one or more optional solvents and optional additives in any order.

Processing of the photoimageable or photoresist compositions may be in any conventional manner. For example, a photoresist layer, either formed from a liquid composition or transferred as a layer from a dry film, is applied to a substrate. When a liquid photoresist composition is used, it may be applied to a substrate by any known means, such as spinning, dipping, roller coating and the like.

The photoresist compositions may be used on a variety of substrates used in the manufacture of electronic devices such as printed wiring boards and integrated circuits. Suitable substrates include copper surfaces of copper clad boards, printed wiring board inner layers and outer layers, wafers used in the manufacture of integrated circuits and the like.

Once the photoresist is applied to the substrate, it is imaged or exposed to actinic radiation through appropriate artwork. Upon exposure to actinic radiation, a free-radical polymerization initiator is believed to be generated from the light sensitive compound of the present invention. A pendent ketone substituent, is shown in formula I above, is believed to be the source of the free-radical and may be considered a built-in photoinitiator. In the case of a negative-acting photoresist, exposure of actinic radiation polymerizes the hycrophilic compound which generates the free-radical or cross-linking agent in exposed areas, resulting in a cross-linked structure that is resistant to developer. Next, the uncured photoresist is developed such as by using dilute alkaline aqueous solution. Suitable developers include 1-3 wt% aqueous solutions of sodium hydroxide or potassium hydroxide, or 0.5-1 wt% sodium or potassium carbonate. Organic based developers, such as tetraalkylammonium hydroxide based developers, may be used but are less preferred. During such development, acidic groups of the binder polymers form salts which render the binder polymers soluble and removable. Thus, the present invention provides a method for forming a relief image including the steps of: a) disposing on a printed wiring board substrate a photoresist composition which includes a component which has an integral free-radical or built-in photoinitiator and any optional additives; b) imaging the photoresist; and c) developing the photoresist.

In the case of negative-acting photoresists applied to copper surfaces of copper clad boards, an etchant may be used after development to remove copper from those areas where the photoresist was removed, thereby forming

a printed circuit. The remaining resist is then removed using a stripper.

The present invention further provides a method of manufacturing a printed wiring board including the steps of: a) disposing on a printed wiring board substrate a photoresist composition which includes a hydrophilic compound containing a built-in photoinitiator of the present invention and any optional components; b) imaging the photoresist; and c) developing the photoresist.

The present photoresist compositions may show enhanced removal as compared to conventional photoresists. Thus, the present invention also provides a method of enhancing the removal of a photoresist composition from a substrate including the step of combining a free-radical generating compound and any optional components to form a photoresist composition; disposing the photoresist composition of a substrate; imaging the photoresist composition; and developing the imaged photoresist composition.

In addition to reducing or eliminating residue and scum formation, photoresist compositions also show good adhesion and good stripping with substantially no loss of chemical resistance. Typically, as adhesion of a dry film photoresist is improved, the photoresist composition is harder to strip. The present photoresist compositions surprisingly provide both good adhesion and good stripping. Additionally, photoresist compositions of the present invention may be cured with 150 $mJ/cm^2$ or less.

Example 1

Synthetic Procedure

60 g of a diacrylate acceptor compound (formula IV below) and 0.5 g of diazabicyclo-undecene (DBU) are weighed into a 500 ml 3-neck round bottom flask equipped with a mechanical stirrer and addition funnel. 15.0 g of an acetoacetate derived donor compound (formula V below) is weighed into the addition funnel. The acceptor compound and DBU are mixed for 5 minutes prior to addition of the donor compound. The donor compound is then added dropwise to the stirred acceptor/DBU mixture over a 15 minute period. The solution is warmed to 54 degrees Celsius after addition of the donor compound is complete. After the exotherm subsided in 100 minutes, a viscous yellow liquid is obtained which does not gel upon standing.

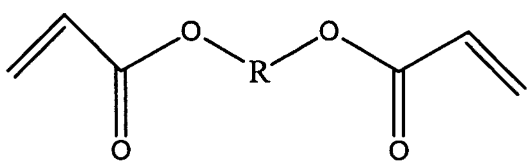

IV

where R is a radical derived from a urethane oligomer having a formula:

$$CH_2=C(CH_3)CO\text{-}O\text{-}(\text{-}CH_2\text{-}CH_2\text{-}O\text{-})_{5\text{-}6}\text{-}(\text{-}CO\text{-}CH_2\text{-}CH_2\text{-}CH_2\text{-}CH_2\text{-}CH_2\text{-}O)_3\text{-}CO\text{-}NH\text{-}$$

$$(CH_2)_6\text{-}NH\text{-}CO\text{-}(\text{-}O\text{-}CH_2\text{-}CH_2\text{-}CH_2\text{-}CH_2\text{-}CH_2\text{-}CO\text{-})_3\text{-}(\text{-}O\text{-}CH_2\text{-}CH_2\text{-})_{5\text{-}6}\text{-}O\text{-}CO\text{-}C(CH_3)=CH_2.$$

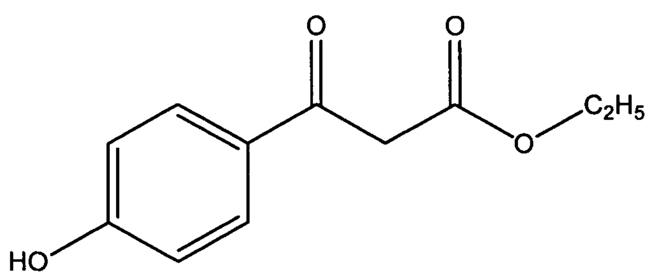

V

The oligomer of the above reaction between donor compound V and acceptor compound V has the following general formula:

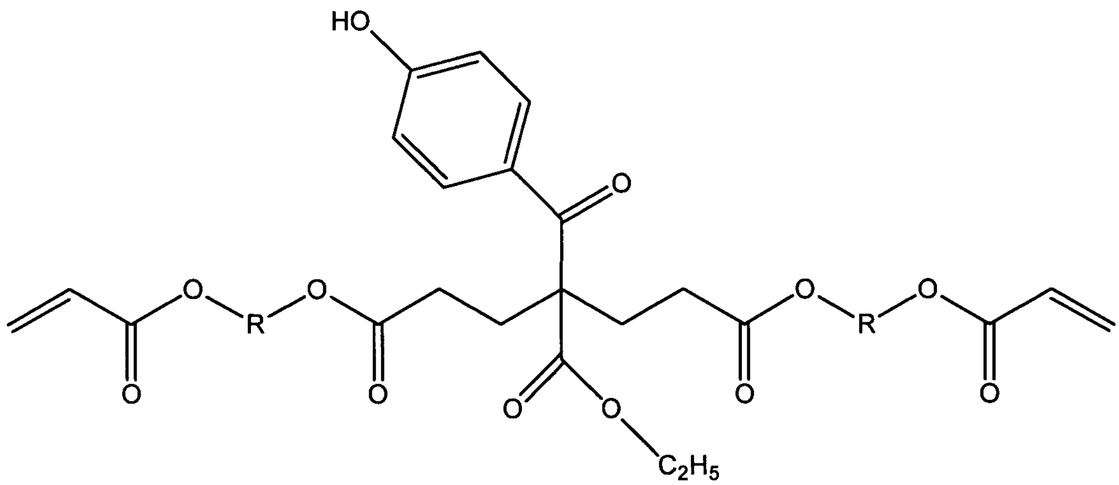

VI

Example 2

Negative-Acting Photoresists

The following ingredients are blended together in the given proportions to provide a negative-acting photoresist composition of the present invention.

| Formulation | |
|---|---|
| Ingredient | Percent by Weight |
| Acrylic copolymer binder[1] | 20 |
| Caprolactone 2 hydroxyethyl methacrylate | 5 |
| trimethylol propane triacrylate (TMPTA) | 15 |
| oligomer[2] | 25 |
| bis(dialkylaminophenyl) ketone | 0.04 |
| tris(dialkylaminophenyl) methane | 0.3 |
| aromaticsulfonamide | 3.5 |
| modifideacridine | 0.2 |

Table Footnotes
[1] 88,000-91,000 Mw copolymer of methyl methacrylate, methacrylic acid, n-butyl acrylate, Tg 90° C., 150 acid number.
[2] Oligomer of Example 1.

A mixture is prepared at about 70% solids in 2-butanone and coated onto a 0.8 mil polyester carrier film and dried to approximately 1% residual VOC's. A thin film of about 1.5 mils thickness is obtained. The films are then laminated at 121° C., 40 psi, 1 meter per minute, onto chemically cleaned 1 oz. copper/0.059 FR-4/1 oz. clad copper laminate and imaged on a 5 kw printer through a silver halide phototool with an adjusted exposure to obtain a copper step of 9 as measured with a Stouffer® 21 step wedge. The panels are then developed in 1% sodium carbonate monohydrate at 29° C. to remove the photoresist in the unexposed portions followed by several spray rinses using tap water and the deionized water. The imaged board is then etched in 2N cupric chloride/HCl at 45° C. The etched boards are then stripped of the imaged and developed photoresist in a 3% sodium hydroxide solution at 49° C., followed by a spray rinse of tap water.

Example 3

A radiation curable solder mask composition is prepared in two parts as follows:

| | Percent By Weight |
|---|---|
| Component A | |
| Esterified styrene-maleic anhydride copolymer[1] | 25.0 |
| Oligomer[2] | 12.5 |
| Pigment | 4.0 |
| Flow promoter | 3.5 |
| Anti-abrasion agent | 3.5 |
| Air release agent | 3.5 |
| Filler | 17.5 |
| Inert diluent | 10.5 |
| Component B | |
| Oligomer[2] | 25.0 |
| Multifunctional epoxy[3] | 30.0 |
| Thermal cross-linking agent[4] | 7.5 |
| Pigment/filler | 12.5 |
| Inert diluent | 25.0 |

[1] Pro 1100, Sartomer Co., Exton, Pa.
[2] Oligomer of Example 1
[3] ECN1299, CibaGeigy Co. (Resin Division)
[4] Dyhard 100S, SKW Inc.

Component A and Component B are mixed, in a ratio of 3:1 at room temperature, and the composition so produced is screen-printed onto printed circuit boards using a 70 Durometer squeegee. The boards are then heat treated at 160° F. for various lengths of time to determine the operating window for pre-baking. The pre-baked boards are then subjected to development using a 10 g/L solution of potassium carbonate at 25°-30° C. for 40 seconds. Boards are baked for 50 minutes and exhibit clean removal of the composition with no residual scum is remaining on the board.
Additional printed circuit boards are coated with the composition in the same manner as above, the composition is dried at 70° C. for twenty minutes, cooled to room temperature, and then identically processed to coat the other side of the board (70° C. drying for 40 minutes). Negatives are brought into contact with the coatings, and each coating is then subjected to 150 millijoules of ultraviolet radiation. The coatings are developed using potassium carbonate solution, 25°-30° C. for 40 seconds. The remaining imagewise distribution of photopolymer is then given a post-exposure of 2-4 joules, and then baked for 1 hour at 150° C.
The so-treated coating is tested for flexibility using the cross-hatch razor technique in which several intersecting lines are cut into the coating. The coating is found to be flexible, with no loss of adhesion.

Example 4

The photoimageable composition of Example 2 is applied to a polyester support sheet and dried. A polyethylene protective sheet is applied to the side of the photoimageable composition opposite the polyester support sheet. A thin film of 1.4 mil thickness is obtained. The polyethylene sheet is removed and the dried film with support sheet is laminated to a copper-clad board using a hot roll laminator. The roll temperature is 122° C.; the roll speed is one meter per minute; and the roll pressure is 2.8 bars. The polyester support sheet is removed, and artwork is laid directly on the photoimageable composition layer. The photoimageable composition is exposed to 81 $mJ/cm^2$ actinic radiation through the artwork. After removal of the artwork, the photoimageable composition is developed in 1% sodium carbonate monohydrate for 35 seconds at 29.4° C. and the board is etched in ammoniacal etchant at pH greater than 9 for 2 minutes at 49° C.

**Claims**

**1.** A photoresist comprising a hydrophilic compound which generates a free-radical integral to the compound.

**2.** The photoresist of claim 1, wherein the hydrophilic compound is derived from the Michael addition reaction of at

least one diketone or acetoacetate derived functional donor compound and at least two multifunctional acrylate receptor compounds.

**3.** The photoresist of claim 2, wherein the hydrophilic compound is an oligomer with a formula:

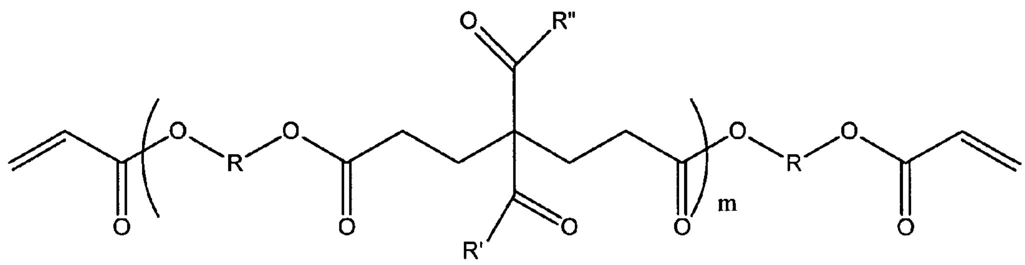

I

where m is an integer of 1 or greater; R' and R" are the same or different and comprise unsubstituted or substituted $(C_6-C_{14})$aryl, linear or branched $(C_1-C_{15})$alkyl, linear or branched $(C_2-C_{15})$hydroxyalkyl, substituted or unsubstituted $(C_5-C_{14})$heterocyclic aryl where the heteroatom is S, N, or O, linear or branched $(C_1-C_5)$ aminylalkyl; or -O-R"' where R"' is the same as R' or R"; and R is a group derived from acid functional monomers, non-acid functional monomers, alkylene oxides, polyesters, urethane oligomers, or mixtures thereof.

**4.** The photoresist of claim 1, wherein the hydrophilic compound comprises from 25% by weight to 95% by weight of the photoresist.

**5.** The photoresist of claim 1, further comprising a polymer binder, α,β ethylenically or acetylenically unsaturated monomers, photoinitiators, plasticizers, rheology modifiers, fillers, dyes, film forming agents, strippers, or mixtures thererof.

**6.** The photoresist of claim 5, wherein the polymer binder is a branched polymeric binder comprising as polymerized units one or more difunctional branch-point monomers having two polymerizable end groups and a backbone comprising one or more base cleavable functionalities.

**7.** The photoresist of claim 1, wherein the free-radical is from a pendent ketone subsitutent.

**8.** A method of forming a pattern comprising:

a) forming a photoresist layer on a substrate, the photoresist comprises a hydrophilic compound which upon exposure to actinic radiation generates a free-radical integral to the compound;

b) imagewise exposing the photoresist to actinic radiation; and

c) developing the imagewise exposed photoresist to form the pattern.

**9.** The method of claim 9, wherein the hydrophilic compound is an oligomer with a formula:

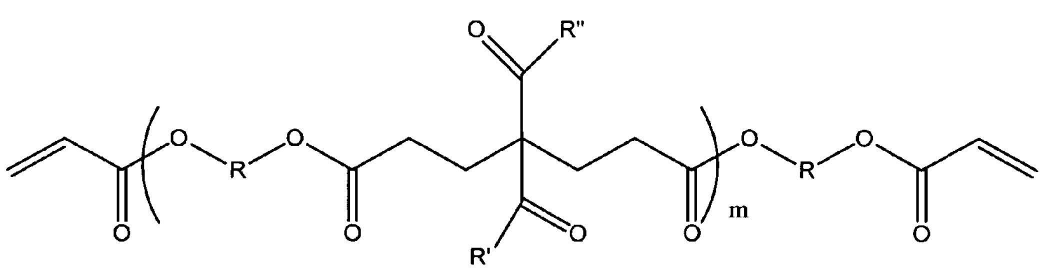

I

where m is an integer of 1 or greater, R' and R" are the same or different and comprise unsubstituted or substituted $(C_6-C_{14})$aryl, linear or branched $(C_1-C_{15})$alkyl, linear or branched $(C_2-C_{15})$hydroxyalkyl, substituted or unsubstituted $(C_5-C_{14})$heterocyclic aryl, or linear or branched $(C_1-C_5)$aminylalkyl; o r -O-R''' where R''' is the same as R' or R"; and R is a group derived from acid functional monomers, non-acid functional monomers, alkylene oxides, polyesters, urethane oligomers, or mixtures thererof.

**10.** The method of claim 9, wherein R', R" and R''' absorb light at a wavelength of 300 nm to 365 nm or greater.